# FASCICULE DE BREVET EUROPEEN

(11) **EP 1 439 600 B1**
(45) Date de publication et mention de la délivrance du brevet: **09.05.2018**
(21) Numéro de dépôt: 04290025.8
(22) Date de dépôt: 07.01.2004
(51) Int. Cl.: H01Q 1/12, H01Q 1/32, H01R 13/20, H01R 12/62, H01R 43/02, H05K 3/34, H05K 3/36, H05K 3/28

(54) **Elément de raccordement par soudage**
Anschlusselement durch Löten
Connecting element by soldering

(30) Priorité: 16.01.2003 DE 10301352
(43) Date de publication de la demande: 21.07.2004
(73) Titulaire: SAINT-GOBAIN GLASS FRANCE, 92400 Courbevoie (FR)
(72) Inventeur: Reul, Bernhard M., 52134 Herzogenrath (DE)
(74) Mandataire: Saint-Gobain Recherche

(56) Documents cités:
- EP-A- 0 405 828
- EP-A- 0 535 491
- EP-A- 0 612 119
- US-A1- 2001 015 285
- US-B1- 6 307 515
- KEIRSTEAD C D: "FLEXIBLE PRINTED CIRCUITS: A DESIGN PRIMER" ASSEMBLY, HITCHCOCK PUBLISHING, CAROL STREAM, US, vol. 31, no. 5, 1 mai 1988 (1988-05-01), pages 32-36, XP002051410 ISSN: 1050-8171

## Description

L'invention concerne un élément de raccordement par soudage pour la réalisation d'une liaison électrique entre au moins un conducteur électrique et une structure conductrice disposée sur la surface d'un support, qui présente les caractéristiques du préambule de la revendication 1.

Par DE-C2 43 04 788, on connaît un contact en feuille à plusieurs couches dont la bande de feuille métallique utilisée comme conducteur électrique est entourée par une enveloppe isolante en deux couches en matière synthétique qui résiste à la chaleur. Dans la zone d'une liaison soudée, le contact en feuille présente un oeillet de soudage. Dans ce but, tant la bande de feuille métallique que les deux feuilles de recouvrement en matière synthétique sont dotées d'une découpe, la découpe de la bande de feuille métallique étant plus petite que celle des feuilles de recouvrement. La bande de feuille métallique est maintenue à une distance définie de la surface du support par la feuille de recouvrement inférieure appliquée sur le support, l'espace intermédiaire pouvant être rempli de soudure fondue qui pénètre par l'oeillet de soudage. On ne peut pas équiper préalablement cette feuille de contact d'un dépôt de soudure.

DE-A1 198 56 663 décrit un dispositif de contact similaire dans lequel plusieurs surfaces de contact électrique sont reliées par soudage à des surfaces de raccordement correspondantes d'une structure conductrice. Dans la région des emplacements de soudage, les feuilles de contact sont recouvertes d'une feuille de recouvrement fermée sur le côté non tourné vers le support, une feuille de recouvrement qui recouvre la surface du support et qui est disposée sur le côté opposé étant dotée d'une découpe qui entoure l'ensemble de l'emplacement de soudage. La zone de soudage est en outre entourée d'une couche d'adhésif qui doit la protéger vis-à-vis de l'extérieur.

L'objet de l'invention est de créer un élément de raccordement par soudage dans lequel un dépôt pré-installé de soudage peut être comprimé pour atteindre une épaisseur minimale définie de manière à obtenir une répartition régulière et sûre de la soudure sous la poussée d'un outil de soudage placé de l'autre côté.

On devra également proposer un procédé de réalisation d'un raccordement soudé à l'aide de cet élément de raccordement par soudage.

Selon l'invention, pour ce qui concerne le raccordement par soudage, cet objet est atteint avec les caractéristiques de la revendication 1. Les caractéristiques de la revendication 9 fournissent un procédé correspondant. Les caractéristiques des revendications qui dépendent des revendications indépendantes respectives fournissent des développements avantageux de ces objets.

Par une harmonisation mutuelle de l'épaisseur de la feuille de recouvrement, de la surface de sa découpe dans la région de la surface de contact et du volume de métal d'un dépôt de soudure à appliquer sur la surface de contact, on crée un espace prédéfini qui, lors de la fusion de la soudure, est rempli de soudure sans excès ni insuffisance avec une reproductibilité élevée et de manière largement indépendante des autres conditions. Dans une opération de fabrication industrielle en grande série, cette disposition permet une augmentation de la qualité des raccordements par soudage.

Il faut remarquer que fondamentalement, cet élément de raccordement par soudage peut être constitué uniquement d'une feuille de recouvrement inférieure et du conducteur électrique (libre) le plus proche de la surface de contact, la surface de contact devant dans ce cas être légèrement plus grande que la découpe dans la feuille de recouvrement pour obtenir ainsi un espace qui peut finalement être fermé par la surface de contact et le bord de la découpe en plus de la surface du support et de la surface de raccordement au moins prévue.

La feuille de support est alors utilisée comme un distanceur qui permet d'obtenir une soudure dont l'épaisseur est définie de manière précise. Il faut évidemment que son matériau résiste suffisamment à la pression pour résister sans se déformer à la poussée non négligeable d'un outil. Il n'est alors plus nécessaire de limiter de manière compliquée l'avancement d'un outil de soudage. Au contraire, des opérations de soudage guidées automatiquement, par soudage thermique (tampon chauffé), soudage par induction avec contre-appui ou même soudage manuel à l'aide d'un piston de soudage manuel peuvent fournir une soudure de forme nette et reproductible de manière définie.

En outre, un contrôle visuel des influences thermiques sur le conducteur plat peut être réalisé de manière particulièrement bonne par "changement de teinte" sur des feuilles de recouvrement de type partiellement transparent, c'est-à-dire éventuellement aussi par des détecteurs optiques, en plus d'une évaluation du signal.

Avec l'élément de raccordement par soudage décrit ici, on peut ainsi traiter de manière reproductible même de grandes surfaces de contact soudées, de sorte que des raccordements de conducteurs de chauffage sur des vitres de véhicules peuvent être réalisés avec des liaisons soudées malgré la densité de courant relativement élevée de la technique des conducteurs plats.

Il peut être avantageux que le conducteur électrique présente une résistance accrue à la flexion dans toute la région de sa surface de contact et de la découpe dans la feuille de recouvrement. De cette manière, on assure également une épaisseur constante et reproductible de la soudure. Si un recouvrement arrière ou une feuille de recouvrement arrière sont prévus, ils peuvent également contribuer à la rigidité souhaitée. Cependant, en règle générale, on sélectionnera et on utilisera l'outil de soudage de manière à ce que le conducteur ou sa surface de contact ne fléchissent pas dans l'espace défini pour la soudure qu'il faut faire fondre.

Il est évident que l'élément de raccordement par soudage selon l'invention peut être utilisé à la fois pour des raccordements simples et pour des raccordements multiples, et dans ce dernier cas, on pourra faire fondre simultanément la totalité du dépôt de soudure de manière connue, par une conception appropriée des surfaces de contact et avec des outils appropriés.

Lorsque l'élément de raccordement par soudage a été monté sur la vitre d'un véhicule, la zone du raccordement sera de préférence protégée contre les influences extérieures à l'aide d'un scellement adhésif.

D'autres détails et avantages de l'objet de l'invention ressortent du dessin d'un exemple de réalisation et de sa description, dans laquelle on entre plus en détail ci-dessous.

Dans le dessin, et dans une représentation simplifiée et non à l'échelle :
la figure 1 représente une vue globale d'une vitre de véhicule dotée d'un élément de raccordement par soudage selon l'invention,
la figure 2 représente une vue en plan du côté de la surface de contact de l'élément de raccordement par soudage,
la figure 3 est une vue en coupe de la vitre de la figure 1 dans la région de la ligne III-III, avant la réalisation des liaisons soudées et
la figure 4 est une vue en coupe de la vitre, analogue à celle de la figure 3, après la réalisation des liaisons soudées.

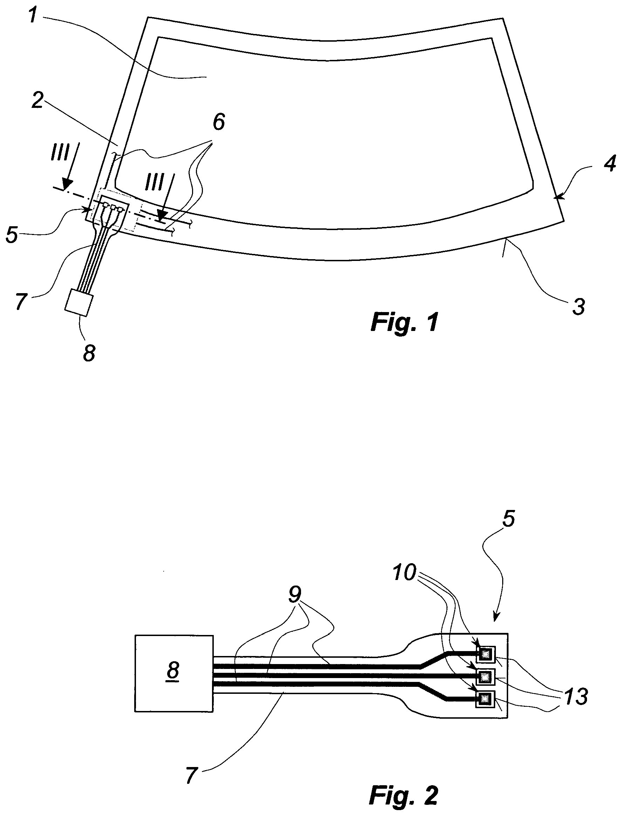

Dans la figure 1, une vitre 1 qui peut être une vitre composite en verre et/ou en matière synthétique ou une vitre monolithique, porte le long de son bord périphérique un revêtement opaque 2. Celui-ci entoure le champ de vision de la vitre par ailleurs transparente et recouvre une bordure 4 particulièrement large le long d'un bord courbe (inférieur) 3 de la vitre 1. Dans un coin de cette bordure 4, une zone de raccordement 5 dans laquelle plusieurs pistes conductrices 6 d'une structure conductrice, qui ne sont représentées ici qu'en partie, se prolongent en des surfaces de raccordement qui sont rassemblées étroitement, est prévue de manière connue en soi sur une surface de la vitre. On voit ici la surface de la vitre 1 qui est dirigée vers l'espace intérieur du véhicule lorsqu'elle a été montée sur un véhicule.

Dans la zone de raccordement 5 est disposé un élément 7 de raccordement par soudage, que l'on a représenté ici à une échelle exagérée et qui, de manière également connue en soi, sert à mettre simultanément en contact électrique les surfaces de raccordement, rassemblées dans la zone de raccordement 5, de la structure conductrice et des composants électriques disposés hors de la vitre (amplificateur, unités de commande, source de tension). A son extrémité libre opposée à la vitre 1, on a indiqué symboliquement une fiche multiple 8 qui, lorsque la vitre 1 est montée, peut être reliée au circuit de bord d'un véhicule ou aux composants mentionnés ci-dessus.

La structure conductrice peut par exemple être un champ d'antenne (par exemple antenne dite à diversité) et/ou un champ de chauffage imprimé et cuit, un revêtement électriquement conducteur et thermiquement isolant par contact, etc. Dans le présent cadre, sa fonction n'est pas importante et n'est donc pas expliquée plus en détail.

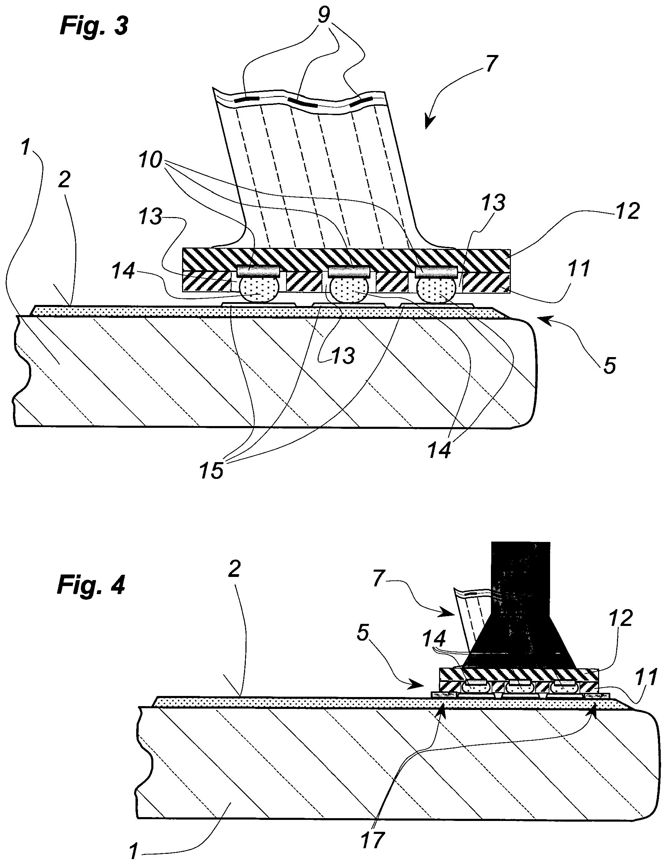

La figure 2 montre une vue agrandie du côté de contact de l'élément 7 de raccordement par soudage réalisé comme conducteur en bande plate et qui, lorsqu'il a été monté, est tourné vers le support ou la surface de la vitre 1. Ainsi qu'on peut déjà le voir dans la figure 1, il comprend trois conducteurs électriques 9 qui s'étendent parallèlement l'un à l'autre et qui présentent la forme de minces bandes de feuille métallique. Dans la partie d'extrémité légèrement élargie de l'élément 7 de raccordement par soudage, ces bandes de feuille métallique se prolongent en surfaces de contact qui sont laissée nues et dotées de dépôts de soudure, voir figure 3.

Ainsi qu'on peut le voir encore mieux dans la figure 3, qui donne une vue d'une coupe transversale à travers la vitre 1 (qui, dans un souci de simplicité, est représentée comme étant une vitre monolithique, bien que ce pourrait également être une vitre composite), les pistes conductrices 9 de l'élément 7 de raccordement par soudage sont englobées essentiellement complètement par deux minces feuilles de recouvrement 11 et 12 électriquement isolantes. De manière connue, elles sont constituées d'une matière synthétique qui résiste à la chaleur, par exemple du polyimide, connu également sous le nom de "Capton".

Regardons dans la direction de l'extrémité libre (ici découpée) de l'élément 7 de raccordement par soudage. Alors que la feuille de recouvrement non tournée vers la surface de la vitre 1 est fermée de manière continue également dans la zone du raccordement de l'élément 7 de raccordement par soudage, la feuille de recouvrement 11 tournée vers la vitre 1 présente pour chacune des trois surfaces de contact 10 de l'élément 7 de raccordement par soudage une découpe 13 dont le bord entoure en anneau la surface de contact 10 à petite distance (voir également la figure 2). On peut ici mieux voir que chaque surface de contact 10 est dotée d'un dépôt de soudure 14, chacun de ces dépôts étant dimensionné à un volume de soudure défini.

L'élément 7 de raccordement par soudage est alors appliqué avec les dépôts de soudure 14 sur les surfaces de raccordement 15 réalisées dans la zone de raccordement 5 de la vitre 1, les points d'extrémité formant les pistes conductrices 6 associées représentées dans la figure 1.

Pour réaliser la liaison par soudage, on place, ainsi qu'on l'a représenté dans la figure 4, un outil de soudage 16 approprié au-dessus de toute la surface de la zone de raccordement 5 située sur la surface de l'élément 7 de raccordement par soudage tournée vers la vitre 1. Cet outil appliquera au moins la force de poussée mécanique nécessaire ; il peut également apporter l'énergie nécessaire pour faire fondre le dépôt de soudure 14 ("thermode"). On peut apporter directement de la chaleur qui traverse la feuille supérieure de recouvrement, ou faire fondre le dépôt de soudure par chauffage par induction. Cette dernière technique est également possible avec un outil approprié (non représenté ici) depuis le côté de la vitre 1 qui n'est pas tourné vers la zone de raccordement 5 ; l'outil 16 est alors uniquement utilisé pour maintenir mécaniquement l'élément 7 de raccordement par soudage.

La figure 4 montre l'état de la zone de raccordement immédiatement après la fusion du dépôt de soudure 14. Si on la compare à la figure 3, on voit que l'élément 7 de raccordement par soudage s'est légèrement enfoncé vers la surface de la vitre 1. On peut voir que les bords de découpe 13 dans la feuille de recouvrement 11 sont situés sur les surfaces de raccordement 15. De cette manière, ils agissent comme distanceurs en ne permettant pas à l'élément 7 de raccordement par soudage ou à ses surfaces de contact 10 de se rapprocher davantage de la surface de raccordement 15.

En réalité, les surfaces de raccordement 15 ne débordent que de quelques dixièmes de millimètres de la surface de la vitre 1 et du revêtement opaque 2 ; par conséquent, dans la réalité, le côté inférieur de l'élément 7 de raccordement par soudage et de la feuille de recouvrement 11 située par-dessous repose à la surface de la vitre et garantit ainsi de manière sûre l'écart souhaité entre les surfaces de contact 10 et les surfaces de raccordement 15. Un écrasement latéral de la soudure en excès ou une épaisseur trop faible de soudure dans la région de la liaison sont ainsi pratiquement exclus.

De manière connue en soi, la zone de raccordement peut encore être protégée par un scellement adhésif 17 vis-à-vis des influences de l'environnement (encrassement, humidité). Cela peut en outre contribuer à délester mécaniquement la zone du raccordement et les emplacements soudés terminés. Il est évident que le scellement 17 peut aussi bien être appliqué sur l'élément 7 de raccordement par soudage lui-même ou sur la zone de raccordement 5 avant le placement de l'élément 7 de raccordement par soudage sur la vitre, par exemple sous la forme d'un ruban adhésif double face ou similaire. On peut également réaliser le scellement après le soudage à l'aide d'une colle pâteuse, ce qui présente l'avantage d'éviter tout dommage thermique par la chaleur du soudage.

## Revendications

1. Elément (7) de raccordement par soudage comprenant au moins un conducteur électrique (9) se prolongeant chacun par une surface de contact (10) destinée à être soudée à une structure conductrice prévue sur un support (1), le dit au moins un conducteur électrique (9) étant recouvert au moins sur le côté qui doit être tourné vers le support (1) par une feuille de recouvrement (11, 12) isolante qui est dotée, pour chacune des surfaces de contact (10), d'une découpe (13) dont le bord entoure en anneau la surface de contact (10) associée,
**caractérisé en ce que** :
- un dépôt pré-installé de soudure (14) est appliqué à la surface de contact (10) ;
- le dépôt de soudure (14) présente un volume de métal prédéterminé ; et
- l'épaisseur de la feuille de recouvrement (11) et la surface de sa découpe (13) dans la zone de la surface de contact (10) sont dimensionnées pour créer un espace qui loge en partie le dépôt de soudure (14) et qui est destiné à être exactement rempli sans excès ni insuffisance par la soudure après fusion de celle-ci.

2. Elément de raccordement par soudage selon la revendication 1, **caractérisé en ce que** le dit au moins un conducteur électrique (9) comprend une bande de feuille métallique (9) électriquement conductrice et **en ce que** la dite feuille de recouvrement (11, 12) comprend une enveloppe isolante (11, 12) en plusieurs couches qui entoure la dite au moins une bande de feuille métallique (9).

3. Elément de raccordement pas soudage selon l'une des revendications précédentes, **caractérisé en ce qu'**il comprend une pluralité de conducteurs électriques (9) qui se prolongent chacun en une surface de contact (10) à souder, et **en ce que** la feuille de recouvrement (11, 12) comprend une pluralité de découpes (13) associées entourant chacune une des surfaces de contact (10).

4. Elément de raccordement par soudage selon l'une des revendications précédentes, **caractérisé en ce que** la feuille de recouvrement (11) résiste suffisamment à la pression pour ne pas se déformer même lors d'une poussée non négligeable d'un outil de soudage (16) appliqué sur le côté de l'élément de raccordement par soudage qui n'est pas tourné vers le support (1).

5. Elément de raccordement par soudage selon l'une des revendications précédentes, **caractérisé en ce que** le conducteur électrique présente dans toute la région de la surface de contact et de la découpe dans la feuille de recouvrement une résistance accrue à la flexion.

6. Utilisation d'un élément de raccordement par soudage selon l'une des revendications précédentes pour assurer le contact électrique entre une structure conductrice prévue sur une vitre, en particulier une vitre de véhicule, en particulier d'une structure d'antenne et/ou une structure de conducteur de chauffage, et des composants électriques associés.

7. Vitre de véhicule, en particulier vitre en verre, comprenant :
- une structure conductrice avec des pistes conductrices (6) ; et
- au moins un élément (7) de raccordement par soudage selon l'une des revendications 1 à 5 précédentes, disposé sur une zone de raccordement (5) de la structure conductrice.

8. Vitre pour véhicule selon la revendication 7, dans laquelle la zone de raccordement (5) est protégée des influences extérieures au moyen d'un scellement adhésif (17) .

9. Procédé de soudage d'un élément (7) de raccordement par soudage selon l'une des revendications 1 à 5 précédentes sur une structure conductrice prévue sur un support (1), **caractérisé par** les étapes qui consistent à :
- réaliser la découpe pour chaque surface de contact individuelle de telle sorte que sa surface et l'épaisseur de la feuille de recouvrement délimitent dans la zone de la surface de contact un espace prédéfini logeant en partie le dépôt de soudure, cet espace devant être exactement rempli sans excès ni insuffisance lors de la fusion de la soudure,
- appliquer sur la surface de contact un dépôt de soudure qui contient une quantité de soudure qui correspond au volume de la découpe recouverte par le support,
- appliquer la feuille de recouvrement sur le support et appliquer la surface de contact avec le dépôt de soudure sur une surface de raccordement associée de la structure conductrice,
- utiliser un outil de soudage dans la région de la surface de contact et
- faire fondre la soudure pour réaliser la liaison électrique permanente.

10. Procédé selon la revendication 9, **caractérisé en ce que** la chaleur de fusion du dépôt de soudure est créée par un outil de soudage appliqué sur le côté du conducteur qui n'est pas tourné vers le support et qui sert également de contre-appui mécanique.

11. Procédé selon la revendication 9, **caractérisé en ce que** la chaleur de fusion du dépôt de soudure est créée par l'apport d'énergie, en particulier par chauffage du dépôt de soudure par induction, qui traverse le support, l'outil de soudage appliqué sur le côté du conducteur qui n'est pas tourné vers le support constituant un contre-appui mécanique.

## Patentansprüche

1. Schweißanschlusselement (7), das mindestens einen elektrischen Leiter (9) umfasst, der sich jeweils durch eine Kontaktoberfläche (10) verlängert, die dazu bestimmt ist, an eine leitfähige Struktur, die auf einem Träger (1) vorgesehen ist, geschweißt zu werden, wobei der mindestens eine elektrische Leiter (9) mindestens auf der Seite, die zu dem Träger (1) gerichtet sein soll, durch ein isolierendes Abdeckblatt (11, 12) abgedeckt ist, das auf jeder seiner Kontaktoberflächen (10) mit einem Ausschnitt (13) versehen ist, dessen Rand die dazu gehörende Kontaktoberfläche (10) ringförmig umgibt,
**dadurch gekennzeichnet, dass**:
- eine vorab installierte Ablagerung von Schweißmaterial (14) auf der Kontaktoberfläche (10) aufgebracht ist;
- die Schweißmaterialablagerung (14) ein vorbestimmtes Metallvolumen aufweist, und
- die Stärke des Abdeckblatts (11) und die Oberfläche seines Ausschnitts (13) in der Zone der Kontaktoberfläche (10) bemessen sind, um einen Raum zu schaffen, der die Schweißmaterialablagerung (14) zum Teil aufnimmt und dazu bestimmt ist, präzis ohne Überschuss oder Mangel von dem Schweißmaterial nach dessen Schmelzen gefüllt zu sein.

2. Schweißanschlusselement nach Anspruch 1, **dadurch gekennzeichnet, dass** der mindestens eine elektrische Leiter (9) ein elektrisch leitendes Metallblattband (9) umfasst, und dass das Abdeckblatt (11, 12) einen isolierenden Mantel (11, 12) in mehreren Schichten umfasst, der das mindestens eine Metallblattband (9) umgibt.

3. Schweißanschlusselement nach einem der vorhergehenden Ansprüche, **dadurch gekennzeichnet, dass** es eine Vielzahl elektrischer Leiter (9) umfasst, die sich jeweils in einer zu schweißenden Kontaktoberfläche (10) verlängern, und dass das Abdeckblatt (11, 12) eine Vielzahl dazugehörender Ausschnitte (13) umfasst, die jeweils eine der Kontaktoberflächen (10) umgeben.

4. Schweißanschlusselement nach einem der vorhergehenden Ansprüche, **dadurch gekennzeichnet, dass** das Abdeckblatt (11) dem Druck ausreichend standhält, um sich auch bei einem nicht vernachlässigbaren Schub eines Schweißwerkzeugs (16), das auf der Seite des Schweißanschlusselements, die nicht zu dem Träger (1) gerichtet ist, angelegt wird, nicht zu verformen.

5. Schweißanschlusselement nach einem der vorhergehenden Ansprüche, **dadurch gekennzeichnet, dass** der elektrische Leiter in dem gesamten Bereich der Kontaktoberfläche und des Ausschnitts in dem Abdeckblatt eine erhöhte Biegefestigkeit aufweist.

6. Einsatz eines Schweißanschlusselements nach einem der vorhergehenden Ansprüche, um den elektrischen Kontakt zwischen einer leitfähigen Struktur, die auf einer Glasscheibe, insbesondere einer Fahrzeugscheibe, insbesondere einer Antennenstruktur und/oder einer Heizleiterstruktur sowie ihrer dazugehörenden elektrischen Bauteile vorgesehen ist, sicherzustellen.

7. Fahrzeugscheibe, insbesondere Glasscheibe, umfassend:
- eine leitfähige Struktur mit Leiterbahnen (6), und
- mindestens ein Schweißanschlusselement (7) nach einem der vorhergehenden Ansprüche 1 bis 5, das auf einer Anschlusszone (5) der leitfähigen Struktur angeordnet ist.

8. Scheibe für Fahrzeug nach Anspruch 7, wobei die Anschlusszone (5) vor äußeren Einflüssen mittels einer Klebeversiegelung (17) geschützt ist.

9. Verfahren zum Schweißen eines Schweißanschlusselements (7) nach einem der vorhergehenden Ansprüche 1 bis 5 auf einer leitfähigen Struktur, die auf einem Träger (1) vorgesehen ist, **gekennzeichnet durch** die Schritte, die aus Folgendem bestehen:
- Herstellen des Ausschnitts für jede einzelne Kontaktoberfläche derart, dass ihre Oberfläche und die Stärke des Abdeckblatts in der Zone der Kontaktoberfläche einen vordefinierten Raum abgrenzen, der die Schweißmaterialablagerung zum Teil aufnimmt, wobei dieser Raum präzis ohne Überschuss oder Mangel bei dem Schmelzen der Schweißung gefüllt werden muss,
- Aufbringen auf der Kontaktoberfläche einer Schweißmaterialablagerung, die eine Schweißmaterialmenge enthält, die dem Volumen des Ausschnitts, der durch den Träger abgedeckt ist, entspricht,
- Anlegen des Abdeckblatts auf dem Träger und Aufbringen der Kontaktoberfläche mit der Schweißmaterialablagerung auf einer Anschlussoberfläche, die zu der leitfähigen Struktur gehört,
- Verwenden eines Schweißwerkzeugs in dem Bereich der Kontaktoberfläche und
- Schmelzen des Schweißmaterials, um die dauerhafte elektrische Verbindung herzustellen.

10. Verfahren nach Anspruch 9, **dadurch gekennzeichnet, dass** die Schmelzwärme der Schweißmaterialablagerung durch ein Schweißwerkzeug geschaffen wird, das auf der Seite des Leiters, die nicht zu dem Träger gerichtet ist, und die auch als mechanische Gegenauflage dient, angelegt wird.

11. Verfahren nach Anspruch 9, **dadurch gekennzeichnet, dass** die Schmelzwärme der Schweißmaterialablagerung durch die Zufuhr von Energie geschaffen wird, insbesondere durch Heizen der Schweißmaterialablagerung durch Induktion, die den Träger durchquert, wobei das Schweißwerkzeug, das auf der Seite des Leiters angelegt wird, die nicht zu dem Träger gerichtet ist, eine mechanische Gegenauflage bildet.

## Claims

1. Soldering connection element (7) comprising at least one electrical conductor (9), each extended by a contact surface (10) intended to be soldered to a conductive structure provided on a support (1), the said at least one electrical conductor (9) being covered at least on the side which must be turned towards the support (1) by an insulating covering sheet (11, 12) which has a cut-out (13) for each of the contact surfaces (10), the edge of which cut-out surrounds the corresponding contact surface (10) as a ring,
**characterised in that**:
- a pre-installed solder deposit (14) is applied to the contact surface (10);
- the solder deposit (14) has a predetermined volume of metal; and
- the thickness of the covering sheet (11) and the area of its cut-out (13) in the zone of the contact surface (10) are of dimensions to create a space which partly houses the solder deposit (14) and which is intended to be exactly filled with the solder, without excess or shortfall, after melting of the solder.

2. Soldering connection element according to claim 1, **characterised in that** the said at least one electrical conductor (9) comprises an electrically conducting sheet metal strip (9) and **in that** the said covering sheet (11, 12) comprises an insulating envelope (11, 12) in several layers which surrounds the said at least one sheet metal strip (9).

3. Soldering connection element according to any of the previous claims, **characterised in that** it comprises several electrical conductors (9), each of which is extended by a solderable contact surface (10), and **in that** the covering sheet (11, 12) comprises several accompanying cut-outs (13), each surrounding one of the contact surfaces (10).

4. Soldering connection element according to any of the previous claims, **characterised in that** the covering sheet (11) is sufficiently resistant to pressure so as not to deform even under the not inconsiderable pressure of a soldering tool (16) applied to the side of the soldering connection element which is not turned towards the support (1).

5. Soldering connection element according to any of the previous claims, **characterised in that** the electrical conductor has increased resistance to bending in the whole region of the contact surface and of the cut-out in the covering sheet.

6. Use of a soldering connection element according to any of the previous claims to ensure electrical contact between a conductive structure provided on a window, particularly a vehicle window, particularly an antenna structure and/or a heat conducting structure, and associated electrical components.

7. Vehicle window, particularly a glass window, comprising:
- a conductive structure with conduction paths (6); and
- at least one soldering connection element (7) according to any of the previous claims 1 to 5, positioned on a connection zone (5) of the conductive structure.

8. Vehicle window according to claim 7, in which the connection zone (5) is protected from external influences by means of an adhesive seal (17).

9. Process for soldering a soldering connection element (7) according to any of the previous claims 1 to 5 on a conductive structure provided on a support (1), **characterised by** steps which consist in:
- creating the cut-out for each individual contact surface in such a way that its area and the thickness of the covering sheet define, in the zone of the contact surface, a predefined space partly housing the solder deposit, this space having to be exactly filled with the solder, without excess or shortfall, on melting of the solder,
- applying to the contact surface a solder deposit which contains a quantity of solder equivalent to the volume of the cut-out covered by the support,
- applying the covering sheet to the support and applying the contact surface with the solder deposit to an associated connection surface of the conductive structure,
- using a soldering tool in the region of the contact surface and
- melting the solder to create the permanent electrical connection.

10. Process according to claim 9, **characterised in that** the heat for melting the solder deposit is created by a soldering tool applied to the side of the conductor which is not turned towards the support, which also serves as a mechanical counter-bearing.

11. Process according to claim 9, **characterised in that** the heat for melting the solder deposit is created by a supply of energy, particularly by induction heating of the solder deposit, which passes through the support, the soldering tool applied to the side of the conductor which is not turned towards the support constituting a mechanical counter-bearing.
